Europäisches Patentamt

European Patent Office

Office européen des brevets

(19)

(11) EP 0 887 942 A1

(12) **EUROPEAN PATENT APPLICATION**

(43) Date of publication:
30.12.1998 Bulletin 1998/53

(51) Int. Cl.$^6$: **H03M 13/00**

(21) Application number: 97121772.4

(22) Date of filing: 10.12.1997

(84) Designated Contracting States:
AT BE CH DE DK ES FI FR GB GR IE IT LI LU MC
NL PT SE
Designated Extension States:
AL LT LV MK RO SI

(30) Priority: 23.06.1997 US 880349
17.11.1997 EP 97120105

(71) Applicant: QUALCOMM INCORPORATED
San Diego, California 92121 (US)

(72) Inventor: Wolf, Jack K.
San Diego, California 92037 (US)

(74) Representative:
Wagner, Karl H., Dipl.-Ing. et al
WAGNER & GEYER
Patentanwälte
Gewürzmühlstrasse 5
80538 München (DE)

(54) **High rate trellis coding and decoding method and apparatus**

(57)     A method and apparatus for constructing high rate trellis codes for PSK modulation that can be encoded and decoded using the encoder (21) and decoder for a rate 1/2 punctured convolutional code. In particular, the design of trellis encoders and decoders for 8-PSK modulation for rates 5/6 encoding.

FIGURE 3

EP 0 887 942 A1

Description

BACKGROUND OF THE INVENTION

I. Field of the Invention

The present invention relates to data communications. More particularly, the present invention relates to a novel and improved for encoding and decoding trellis modulated data based upon punctured convolutional codes.

II. Description of the Related Art

The field of data communications is concerned with raising the data throughput of a transmission system with a limited signal to noise ratio (SNR). The use of error correcting circuitry such as the Viterbi decoder allows system tradeoffs to be made with smaller SNRs or higher data rates to be used with the same bit error rate (BER). The decrease in the SNR needed is generally referred to as coding gain. Coding gain may be determined from simulated bit error performance curves. In a graph of simulated bit error performance curves the BER of uncoded and various code rate data is charted against $E_b/N_o$, where $E_b$ is the energy per bit and $N_o$ is the Gaussian White Noise energy per bit. The coding gain at any point along a bit error performance curve for a particular BER level is determined by subtracting the coded $E_b/N_o$ from the uncoded $E_b/N_o$. In the paper "Viterbi Decoding for Satellite and Space Communcation", by J.A. Heller and I. M. Jacobs, IEEE Transactions on Communication Technology, Vol. COM-19, pgs. 835-848, October 1971, extensive results of simulations on various decoder apparatus were reported.

The coding rate and constraint length are used to define the Viterbi decoder. The coding rate (m/n) corresponds to the number of coding symbols produced (n) for a given number of input bits (m). The coding rate of 1/2 has become one of the most popular rates, although other code rates are also generally used. One class of codes with $m \neq 1$ are called punctured codes and are produced by discarding or erasing symbols from the rate 1/n code. The constraint length (K) is the length of the convolutional code used in the encoding of the data. A constraint length of K=7 is typical in convolutional coding schemes. The convolutional encoder can be thought of as an Finite Impulse Response (FIR) filter with binary coefficients and length K-1. This filter produces a symbol stream with $2^{K-1}$ possible states.

The basic principal of the Viterbi algorithm is to take a convolutionally encoded data stream that has been transmitted over a noisy channel and use the properties of the convolutional code to determine the transmitted bit stream. The Viterbi algorithm is a computationally efficient method of updating the conditional probabilities of all $2^{K-1}$ states and finding the most probable bit sequence transmitted. In order to compute this probability, all the conditional probabilities of $2^{K-1}$ states for each bit must be computed. The resulting decision from each of these computations is stored as a single bit in a path memory.

A chainback operation, an inverse of the encoding operation, is performed in which the $p \cdot 2^{K-1}$ decision bits are used to select an output bit, where p is the path memory depth. After many states the most probable path will be selected with a high degree of certainty. The path memory depth must be sufficiently long to allow this probability to approach 1. For a rate 1/2 code, an exemplary path memory depth is about (5 · K), or 35 states. For a rate 7/8 punctured code the optimal depth increases to 96 states.

Constraint lengths of K less than 5 are too small to provide any substantial coding gain, while systems with K greater than 7 are typically too complex to implement as a parallel architecture on a single VLSI device. As the constraint length increases, the number of interconnections in a fully parallel computation section increases as a function of ($2^{K-1}$ · L), where L is the number of bits of precision in the state metric computations. Therefore, where K is greater than 7, serial computation devices are generally used which employ large external random aceess memories (RAMs).

In the paper "Channel Coding with Multilevel/Phase Signal" by G. Ungerboeck, IEEE Transactions on Information Theory, Vol. IT-28, pgs. 55-67, January 1982, a trellis coded modulation (TCM) was described. In Ungerboeck it was shown that within a given spectral bandwidth, it is possible to achieve an Asymptotic Coding Gain of up to 6 dB by employing a rate (n-1)/n convolutional code and doubling the signal set. Unfortunately for each modulation technique and for each bit rate, the maximal coding again is achieved by a different convolutional code. Further disclosed were the results of a search for all convolutional codes for several rates and modulation techniques, and the best codes presented.

In the paper "A Pragmatic Approach to Trellis-Coded Modulation" by A.J. Viterbi, J.K. Wolf, E Zehavi and R. Padovani, IEEE Communications Magazine, pgs. 11-19, July 1989, a pragmatic approach to trellis coded modulation (PTCM) was disclosed. The underlying concept therein is that a somewhat lower coding gain is achievable by a PTCM based on the "industry standard" rate 1/2, K=7 convolutional code. Although a lower coding gain is realized, it is very close to the coding gain of Ungerboeck at BERs of interest.

Trellis coding is an attractive coding technique since it possesses an aspect which other coding techniques lack. The power of trellis coding lies in the fact that even though no apparent coding operation is performed on any other bit than the least significant bit of the input data, the decoder is able to provide error correction on all bits. Generally the use of TCM techniques to achieve efficient use of power-bandwidth resources has been limited to low speed applications in digital signal processor implementations. The use of PTCM techniques enable VLSI implementations of an encoder/decoder capable of operating at high rates. A decoder using PTCM techniques is capable of handling different modulation techniques, such as M-ary phase-shift keying (M-ary PSK) including Binary PSK (BPSK), Quadrature PSK (QPSK), 8-PSK, and 16-PSK.

In the paper, "Development of Variable-Rate Viterbi Decoder and Its Performance Characteristics," Sixth International Conference on Digital Satellite Communications, Phoenix Arizona, September, 1983 Y. Yasuda, Y. Hirata, K. Nakamura and S. Otani discuss a method whereby a class of high rate binary convolutional codes can be constructed from a single lower rate binary convolutional code. The advantage of punctured codes for binary transmission is that the encoders and decoders for the entire class of codes can be constructed easily by modifying the single encoder and decoder for the rate 1/2 binary convolutional code from which the high rate punctured code was derived. The current invention will be concerned primarily with rate (m-1)/m binary convolutional codes (m a positive integer greater than or equal to 3) formed from puncturing a particular rate 1/2 convolutional code which has become a de-facto standard of the communications industry. This code has constraint length 7 and generator polynomials $G_1(D) = 1+D^2+D^3+D^5+D^6$ and $G_2(D) = 1+D+D^2+D^3+D^6$. Indeed, many commercial VLSI convolutional encoder and decoder chips (including a device marketed under Part No. Q1875 by QUALCOMM Incorporated of San Diego, California) contain encoders and decoders for punctured binary codes using this de-facto standard rate 1/2 code.

It is therefore an object of the present invention to provide a novel method and circuitry for encoding and decoding trellis data using punctured rate 1/2 convolutional encoders.

## SUMMARY OF THE INVENTION

The present invention is a novel and improved method and apparatus for encoding and decoding trellis modulated data based upon punctured rate 1/2 convolutional codes. In accordance with the present invention a trellis encoder and decoder are disclosed in which a circuit is provided that encodes and decodes based upon punctured rate 1/2 convolutional encoding.

In a rate 5/6 punctured trellis encoder for 8-PSK modulation, each input data bit set is comprised of five bits. In a 16-PSK modulation scheme, using rate 7/8 encoding, each input data bit set is comprised of seven bits. In a general M-PSK modulation scheme, using rate $(\log_2 M-1)/\log_2 M$, each input data bit set is comprised of $\log_2 M-1$ bits. The encoder receives a set of input data bits of a sequence of input data bit sets, encodes a subset of the input data bits according to a punctured convolutional code and groups the output symbols. The groups of typically three or four bits are then passed in to a 8-ary or 16-ary modulator.

The decoder uses a Viterbi decoder to generate an error corrected estimates of the original data. The Viterbi decoder uses branch metrics in the decoding process developed from information contained in the phase of the received signal. The Viterbi decoder output symbols are convolutionally encoded to produce corresponding re-encoded symbols for use in the recovery of the uncoded symbols. The re-encoded symbols from the convolutional encoder are supplied to error correction logic along with an uncorrected estimate of the transmitted data, which based solely on the received phase of the modulated data. The error correction logic checks according to the re-encoded bits and the uncorrected first estimates of the transmitted data provides a corrected estimate of the transmitted data.

In an alternative and improved implementation, additional circuitry is provided that provides for resolving phase ambiguities that are in traditional implementations of the Viterbi decoder unresolveable. In this alternative and improved implementation, each of the uncoded input data bits is differentially encoded with a bit that has been convolutionally encoded with the punctured convolutional encoder.

In improved implementation, the decoder requires additional circuitry to resolve the phase ambiguities. The additional circuitry includes differential decoders for and data buffers. The differential decoders differentially decode the unprotected data bits with respect to the protected bits.

## BRIEF DESCRIPTION OF THE DRAWINGS

The features, objects, and advantages of the present invention will become more apparent from the detailed description set forth below when taken in conjunction with the drawings in which like reference characters identify correspondingly throughout and wherein:

Figure 1 is a block diagram of an exemplary generic impelementation a trellis encoder based upon a punctured convolutional encoding;
Figure 2 is a block diagram of an exemplary rate 5/6 punctured trellis encoder for 8-PSK modulation;
Figure 3 is a block diagram of an exemplary rate 7/8 punctured trellis encoder for 8-PSK modulation;

Figure 4 is a block diagram of an exemplary rate 8/9 punctured trellis encoder for 8-PSK modulation;

Figure 5 is a block diagram of a exemplary rate 11/12 punctured trellis encoder for 8-PSK modulation;

Figure 6 is a block diagram of an exemplary controlled differential encoder;

Figure 7 is a block diagram of an exemplary rate 5/6 punctured trellis encoder for 8-PSK modulation with precoding;

Figure 8 is a block diagram of an exemplary rate 5/6 punctured trellis decoder for 8-PSK modulation with precoding; and

Figure 9 is a block diagram of an exemplary controlled differential decoder.

## DETAILED DESCRIPTION OF THE PREFERRED EMBODIMENT

For binary transmission, puncturing is a method whereby a class of high rate binary convolutional codes can be constructed from a single lower rate binary convolutional code. The advantage of punctured codes for binary transmission is that the encoders and decoders for the entire class of codes can be constructed easily by modifying the single encoder and decoder for the rate 1/2 binary convolutional code from which the high rate punctured code was derived. In the invention, the exemplary embodiment uses a rate (m-1)/m binary convolutional codes (m a positive integer greater than or equal to 3) formed from puncturing a particular rate 1/2 convolutional code which has become a de-facto standard of the communications industry. In an exemplary embodiment, the code has constraint length 7 and generator polynomials $G_1(D) = 1+D^2+D^3+D^5+D^6$ and $G_2(D) = 1+D+D^2+D^3+D^6$. Indeed, many commercial VLSI convolutional encoder and decoder chips (including the previously mentioned Q1875 chip from QUALCOMM Incorporated) contain encoders and decoders for punctured binary codes using this de-facto standard rate 1/2 code.

The high rate punctured codes have smaller free Hamming distances then the original unpunctured codes. For example, the above mentioned constraint length 7 code has free Hamming distance equal to 10. When punctured to form higher rate codes, the minimum free Hamming distance decreases as indicated in Table I as follows:

TABLE I

| Minimum Free Hamming Distance of the Punctured Codes Formed From the De-Facto Standard Rate 1/2 Convolutional Code of Constraint Length 7 | | |
| --- | --- | --- |
| Code Rate | Minimum Free Hamming Distance | Number of Minimum Distance Code Words |
| 1/2 | 10 | 36 |
| 2/3 | 6 | 3 |
| 3/4 | 5 | 42 |
| 4/5 | 4 | 12 |
| 5/6 | 4 | 92 |
| 6/7 | 3 | 5 |
| 7/8 | 3 | 9 |

In an alternative implementation, a rate 1/2 convolutional encoder and decoder without puncturing can be used as the engine to construct high rate trellis encoders and decoders for PSK trellis coded modulation. The current invention shows how to construct encoders and decoders for high rate PSK trellis codes using a punctured encoder and decoder for the rate 1/2 convolutional code as the basic building block. The perfomance of these codes is superior to the codes in the alternative implementation for a wide range of code rates. A comparison of the codes formed from these two techniques for trellis coded 8-PSK and 16 PSK modulation is shown below in Table II.

TABLE II

| Modulation | Code Rate | Min. Squared Free Euclidean Distance | |
| --- | --- | --- | --- |
| | | (Not Punctured) | (Punctured) |
| QPSK | 1 (uncoded) | 2.000 | n.a. |

TABLE II (continued)

| Modulation | Code Rate | Min. Squared Free Euclidean Distance | |
|---|---|---|---|
| | | (Not Punctured) | (Punctured) |
| 8-PSK | 2/3 (Q1875) | 4.000 | n.a. |
| | 5/6 | 2.000 | 2.929 |
| | 8/9 | 1.750 | 2.34 |
| | 1 (uncoded) | 0.586 | n.a. |
| 16-PSK | 3/4 (Q1875) | 2.000 | n.a. |
| | 7/8 | 0.586 | 0.7612 |
| | 11/12 | 0.457 | 0.6088 |
| | 1 (uncoded) | 0.152 | n.a. |

A comparison of the performance of some of these codes with previously known codes is given below in Table III.

TABLE 3

1. Rate 5/6 8-PSK vs. uncoded QPSK

25% increase in transmission rate at same bandwidth.

1.7 db improvement in minimum squared Euclidean distance.

2. Rate 8/9 8-PSK vs. uncoded QPSK

33% increase in transmission rate at same bandwidth.

0.7 db improvement in minimum squared Euclidean distance.

3. Rate 5/6 8-PSK vs. uncoded 8-PSK

17% decrease in transmission rate at same bandwidth.

7.0 db improvement in minimum squared Euclidean distance.

4. Rate 8/9 8-PSK vs. uncoded 8-PSK

11% decrease in transmission rate at same bandwidth.

6.0 db improvement in minimum squared Euclidean distance.

5. Rate 7/8 16-PSK vs. uncoded 8-PSK

17% increase in transmission rate at same bandwidth.

1.1 db improvement in minimum squared Euclidean distance.

6. Rate 11/12 16-PSK vs. uncoded 8-PSK

22% increase in transmission rate at same bandwidth.

0.2 db improvement in minimum squared Euclidean distance.

7. Rate 7/8 16-PSK vs. uncoded 16-PSK

12.5% decrease in transmission rate at same bandwidth.

7.0 db improvement in minimum squared Euclidean distance.

8. Rate 11/12 16-PSK vs. uncoded 16-PSK

8% decrease in transmission rate at same bandwidth.

6.0 db improvement in minimum squared Euclidean distance.

Another measure of quality for trellis codes whose encoders and decoders use as their engine a single chip containing a binary convolutional encoder and matched Viterbi decoders is the maximum bit rate (in bits per second) that can be supported by the single chip. A comparison of the maximum bit rate that can be achieved using a single chip that can decode a rate 1/2 binary convolutional code at 20 megabits per second (which is the case for the Q1875 chip) is given below in Table IV. From the table it is seen that the codes discussed in the current invention have better free squared Euclidean distance than the codes of the alternative implementation but have a lower maximum transmission rate than those codes for a single chip implementation. Table IV considers the case for a maximum transmission rate for trellis coded 8-PSK and 16-PSK modulation assuming a 20 Megabit per second chip for a rate 1/2 convolutional code.

TABLE IV

| Modulation | Code Rate | Transmission Rate bps/Hz | Transmission Rate Megabits per Second MHz | |
|---|---|---|---|---|
| | | | (Non-Punctured) | (Punctured) |
| 8-PSK | 5/6 | 2.50 | 100 | 33.3 |
| | 8/9 | 2.67 | 160 | 32.0 |
| | 11/12 | 2.75 | 220 | 31.4 |
| 16-PSK | 7/8 | 3.50 | 140 | 46.6 |
| | 11/12 | 3.67 | 220 | 44.0 |

A series of exemplary implementations are presented for 8-PSK and 16-PSK trellis coded modulation based upon punctured rate 1/2 binary convolutional codes. Throughout the examples, it will be assumed that the phase of the PSK carrier is known exactly at the receiver and that the only perturbation is additive white Gaussian noise. An improvement for mitigating against a phase ambiguity will be described at the end of the detailed embodiment description.

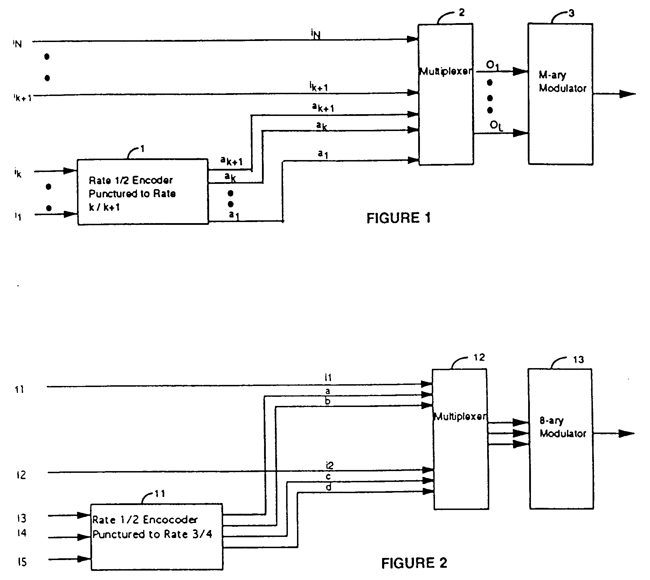

In Figure 1, a set of N input data bits are received at the encoder **1**, k of which (bits $i_1$, $i_2$, ..., $i_k$) are convolutionally encoded using a rate $k/k+1$ encoder based upon a punctured rate 1/2 convolutional encoder **1**. The encoded symbols ($a_1$, $a_2$, ..., $a_k$, $a_k+1$) along with the remaining input bits ($i_k+1$, $i_k+2$,...,$i_N$) are provided to a multiplexer **2**. Muitiplexer **2** combines the encoded symbols with the remaining input data bits so as to provide sets of data to the M-ary modulator **3**. Each set is comprised of $\log_2 M$ elements and are typically provided sequentially to M-ary modulator **3** for transmission.

In the exemplary implementations illustrated in the remaining figures, a specific mapping between binary digits and phases of the PSK signal will be assumed. For 8-PSK this mapping will be 0°=000, 45°=001, 90°=010, 135°=011, 180°=100, 225°=101, 270°=110, and 315°=111. For 16-PSK the mapping will be 0°=000, 22.5°=0001, 45°=0011, 67.5°=0010, 90°=0100, 112.5°=0101, 135°=0111, 157.5°=0110, 180°=100, 202.5°=1101, 225°=1111, 247.5°=1110, 270°=1000, 292.5°=1001, 315°=1011, and 337.5°=1010. Mapping arrangements may readily be made for higher order M-ary modulation schemes using this scheme. Although a modified Gray coding scheme is exemplified in this mapping, it is not critical to the invention such that other mapping schemes may be devised.

Referring to Figure 2, five input lines labeled (i1, i2, i3, i4, i5) are provided to the encoding circuit. These lines are arranged with two single lines i1 and i2, and a bundle of three lines (i3, i4, and i5). The three lines (i3, i4, and i5) are used as inputs to a punctured rate 1/2 convolutional encoder **11**. For example, the puncturing is such that after the input i3, both outputs are taken from the convolutional encoder **11** (denoted a and b), after the input i4 only one of the outputs (corresponding to the polynomial $G_1(D) = 1+D^2+D^3+D^5+D^6$) is taken (denoted c) and after the input i5 the other output (corresponding to the polynomial $G_2(D) = 1+D+D^2+D^3+D^6$) is taken (denoted d). The two lines i1 and i2 are said to carry "uncoded" binary digits while the three lines i3, i4 and i5 are said to carry "coded" binary digits. The four binary digits a, b, c and d are grouped with the uncoded binary digits in the manner shown to produce at the output 6 binary digits on 6 lines. These lines are divided into two bundles of three lines each ((i1,a,b) and (i2,c,d)). The three bits in each bundle should be considered a 3-bit octal number where the bits labeled i1 and i2 are the most significant bits in each of the 3-bit numbers.

Each of the two sets are provided to multiplexer **12** which provides the three bit octal numbers sequentially to the 8-ary modulator **13**. Each octal number will be mapped into one 8-PSK signal so that the trellis coded modulator **13** produces two 8-PSK signals for each 5 bit input. The code is said to be a rate 5/6 trellis code for 8-PSK modulation. Assuming that uncoded 8-PSK can transmit information at 3 bits/Hz, this code will transmit information at 2.5 bits/Hz.

For each transmitted phase, the receiver processes the received waveform and outputs a pair of real numbers (or one complex number) denoted by "I" and "Q". Two of these complex numbers (corresponding to the receiver outputs for the two transmitted phases) are then used as inputs to the decoder for the trellis code. It is assumed that this decoder uses as an engine, a Viterbi decoder matched to the punctured rate 1/2 convolutional code. The branches of the trellis upon which the Viterbi decoder operates are labeled by the pairs (a,b), (c,X) and (X,d) where X denotes the erasure symbol.. Thus, prior to Viterbi decoding, the proper branch metrics for each of the values that (a,b), (c,X) or (X,d) must be computed. The first pair of complex numbers are used to obtain the four branch metrics for (a,b), the next pair of complex numbers are used to obtain the two branch metrics for (c,X) and the two branch metrics for (X,d) and then the process repeats. The calculation of the branch metrics for (a,b) is done in the usual way. That is, for each of the four values that (a,b) can take on, one computes the squared Euclidean distance to the closest of the two signal points that corresponds to that value of (a,b). To calculate the metric for the value (c,X), for c=0 and for c=1, one calculates the squared Euclidean distance to the closest of the four signal points consistent with that value of c. Using the same complex number, one does the same for the metrics for (X,d). The above discussion assumes that as is the case for the Q1875 chip, externally generated branch metrics can be utilized by the decoder. If this is not the case, one can instead predistort the complex numbers so as to artificially obtain the desired branch metrics.

Since at this point in the decoding algorithm, it is not known which branches will be chosen by the Viterbi decoder, the information required to pick the best values for the uncoded diets must be stored. There are several ways to store this information. The most obvious way is to store the two (I,Q) pairs. A more efficient method of storage is to determine for each of the (I,Q) pairs the value of j for which $(j-1)(360°/8) < \tan^{-1}(Q/I) < j(360°/8)$. This requires 3 bits for each (I,Q) pair. The value of "j" is referred to as the "sector information." Given the two values of "j" and the value of (a,b) or (c,d), the best choice for the 2 uncoded binary digits can be determined.

The Viterbi decoder then operates in its normal way to select the best path through the trellis of the rate 1/2 code. The output of this decoder is an estimate of the bits on line i3, i4, and i5. This bit stream is then re-encoded to produce the best estimate of the sequence of (a,b), (c,X) and (X,d) values that correspond to the best path through the trellis. As stated previously, this information along with the sector information is sufficient to give the uncoded bit streams.

Assuming that the PSK signals are placed on the unit circle, the minimum squared Euclidean distance between parallel transitions is 4.0. Since the rate 3/4 punctured code used has free Hamming distance of 5, the trellis code has free squared Euclidean distance of at least $5*(2*\sin(22.5°))^2 = 2.929$. This is the case because of the particular mapping chosen to map 3 binary digits into phases of the 8-PSK signal. In particular, if the two least significant digits differ in one position then the corresponding squared Euclidean distance between the phases is at least $(2*\sin(22.5°))^2$ while if these two least significant digits differ in two positions the squared Euclidean distance between the phases is at least $2*\sin(45°)^2 > 2(2*\sin(22.5°))^2$. Thus, a free Hamming distance of 5 for the rate 3/4 convolutional code translates into a free squared Euclidean distance of $5*(2*\sin(22.5°))^2 = 2.929$. If a rate 3/4 punctured code had been used whose free Hamming distance was at least 7, then the parallel transitions would have dominated since $7*(2*\sin(22.5°))^2 > 4$.

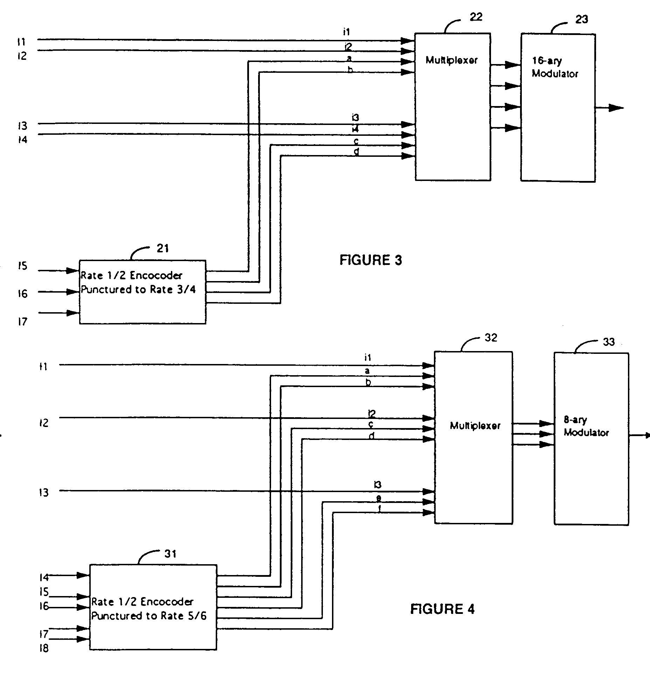

The operation of the rate 7/8 punctured trellis code for 16-PSK modulation is analogous to the 5/6 punctured code with groupings as shown in Figure 3. The operation of this encoder is similar to that for the encoder of Figure 2 with now seven input bits. Encoder **21** produces from three input bits four sysmbols as was discussed with reference to Figure 2. Two uncoded input bits are paired with two coded bits from encoder **21** to form two four-symbol groups which are provided to multiplexer **22**. Multiplexer **22** provides in sequence the four-symbol groups to 16-ary modulator **23**. Each hex number will be mapped into a 16-PSK signal so that the modulator **23** produces two 16-PSK signals for each 7 bit input.

Assuming that the PSK signals are placed on the unit circle, the minimum squared Euclidean distance between parallel transition is 2.00. By an argument similar to that given for the previous example, for the assumed mapping of 4-tuples into 16-PSK phases, the trellis code has free squared Euclidean distance of at least $5*(2*\sin(11.25°))^2 = 0.761$. If a rate 3/4 punctured code had been used whose free Hamming distance was at least 14, then the parallel transitions would have dominated since $14*(2*\sin(11.25°))^2 > 2$.

The encoding circuit of Figure 4 maps 8 input bits into three 8-PSK signals. There are three single lines i1, i2 and i3 and a bundle of five lines (i4, i5, i6, i7, and i8) to the encoding circuit. The bundle of five lines (i4, i5, i6, i7, and i8) are provided to a punctured rate 1/2 convolutional encoder **31**. The puncturing is such that after the input i4, both outputs are taken from the convolutional encoder (denoted a and b), after the input i5 only the first output is taken (denoted c), after the input i6 the second output is taken (denoted d.), after the input i7, again only the first output is taken (denoted e), and after the input i8 only the second output is taken (denoted f). The three lines i1, i2 and i3 are said to carry "uncoded" binary digits while the five lines i4, i5, i6, i7, and i8, are said to carry "coded" binary digits.

The six binary digits a, b, c, d, e, and f are grouped with the uncoded binary digits in the manner shown to produce at the output 9 binary digits on 9 lines. These lines are divided into three bundles of three lines each ((i1,a,b), (i2,c,d); and (i3,e,f)). These bundles are provided to multiplexer **32** which sequentially provides the data on these lines to 8-ary modulator **33**. The three bits in each bundle should be considered a 3-bit octal number where the bits labeled i1, i2 and i3 are the most significant bits in each of the 3-bit numbers. Each octal number will be mapped into one 8-PSK signal so that the trellis coded modulator produces three 8-PSK signals for each 8 bit input. The code is said to be a rate 8/9 trellis code for 8-PSK modulation. Assuming that uncoded 8-PSK can transmit information at 3 bits/Hz, this code will transmit information at 2.67 bits/Hz.

For each transmitted phase, the receiver processes the received waveform and outputs a pair of real numbers (or one complex number) denoted by "I" and "Q". Three of these complex numbers (corresponding to the receiver outputs for the three transmitted phases) are then used as inputs to the decoder for the trellis code. It is assumed that this decoder uses as an engine, a Viterbi decoder matched to the punctured rate 1/2 convolutional code. The branches of the trellis upon which the Viterbi decoder operates are labeled by the pairs (a,b), (c,X), (X,d), (e,X) and (X,f) where X denotes the erasure symbol. Thus, prior to Viterbi decoding, the proper branch metrics for each of the values that (a,b), (c,X), (X,d), (e,X) or (X,f) must be computed. That is, the first pair of complex numbers are used to obtain the four branch metrics for (a,b), the next pair of complex numbers are used to obtain the two branch metrics for (c,X), and for (X,d), the next pair of complex numbers are used to obtain the two branch metrics for (e,X) and for (X,f), and then the process repeats. Again it is assumed that as is the case for the Q1875 chip, externally generated branch metrics can be utilized by the decoder or that one can predistort these inputs to give the desired branch metrics.

Since at this point in the decoding algorithm, it is not known which branches will be chosen by the Viterbi decoder, the information required to pick the best values for the uncoded digits must be stored. There are several ways to store this information. The most obvious way is to store the two (I,Q) pairs. A more efficient method of storage is to determine for each of the (I,Q) pairs the value of j for which $(j-1)(360°/16) < \tan^{-1}(Q/I) < j(360°/16)$. This requires 4 bits for each (I,Q) pair. The value of "j" is referred to as the "sector information." It is easy to verify that given the three values of "j" and the value of (a,b), (c,d), or (e,f) the best choice for the uncoded binary digits can be selected.

The Viterbi decoder then operates in its normal way to choose the best path through the trellis of the rate 1/2 code. The output of this decoder is an estimate of the bits on line i3, i4, i5, i6, i7, and i8. This bit stream is then re-encoded to produce the best estimate of the sequence (a, b, c, d, e, f) that correspond to the best path through the trellis. As stated previously, this information along with the sector information is sufficient to give the uncoded bit streams.

Assuming that the PSK signals are placed on the unit circle, the minimum squared Euclidean distance between parallel transitions is 4.0. Since the rate 5/6 punctured code used has free Hamming distance of 4, the trellis code has free squared Euclidean distance of at least $4*(2*\sin(22.5°))^2 = 2.343$. If a rate 3/4 punctured code had been used whose free Hamming distance was at least 7, then the parallel transitions would have dominated.

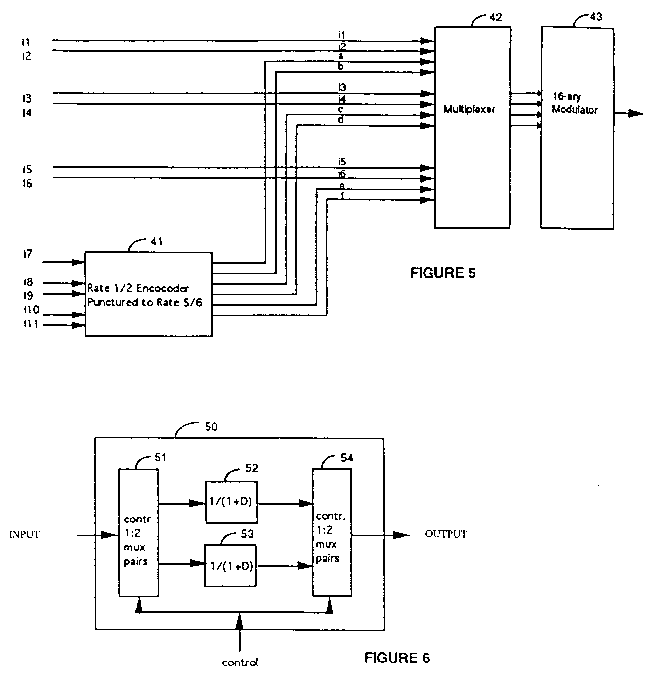

Referring to Figure 5, the operation of the rate 11/12 punctured trellis code is analogous to the 8/9 punctured code with groupings as shown in Figure 5. The operation of this encoder is similar to that for the encoder of Figure 4 with now eleven input bits. Encoder 41 produces from five input bits six sysmbols as was discussed with reference to Figure 4. Two uncoded input bits are paired with two coded bits from encoder 21 to form three four-symbol groups which are provided to multiplexer 42. Multiplexer 42 provides in sequence the four-symbol groups to 16-ary modulator 43. Each hex number will be mapped into a 16-PSK signal so that modulator 23 produces three 16-PSK signals for each 11 bit input.

Assuming that the PSK signals are placed on the unit circle, the minimum squared Euclidean distance between parallel transitions is 2.00. Since the rate 5/6 punctured code used has free Hamming distance of 4, the trellis code has free squared Euclidean distance of at least $4*(2*\sin(11.25°))^2 = 0.609$. If a rate 5/6 punctured code had been used whose free Hamming distance was at least 14, then the parallel transitions would have dominated.

The examples described in the previous section for 8-PSK and 16-PSK utilize a punctured binary rate 1/2 convolutional encoder and matched Viterbi decoder as its basic building block. The basic approach, however can be utilized with any punctured code convolutional code and any modulation scheme. How to construct trellis codes for $2^k$-ary PSK modulation (k>3) based upon any punctured convolutional code is described as follows. Since high rate codes are of principal interest the discussion will only concern the construction of trellis codes of rate (km-1)/km where m is an integer greater than 2.

A trellis code of rate (km-1)/km over $2^k$-ary PSK modulation encodes (km-1) binary digits into m symbols from $2^k$-ary PSK modulation. If one uncoded binary digit for each $2^k$-ary symbol were used, it would result in a total of m uncoded inputs and ((km-1)-m)=((k-1)m-1) coded inputs. This would imply the use of a convolutional code punctured to rate ((k-1)m-1)/(k-1)m. The (k-1)m outputs of the binary convolutional encoder would be broken up into m groups each group containing (k-1) binary digits. The (k-1) binary digits from each group would be combined with one uncoded digit (with the uncoded digit being the most significant bit of the k digits) to form a bundle of k binary digits. The result would be m bundles which are then mapped to m $2^k$-ary symbols. Since the uncoded digit represents parallel transitions in the decoder trellis for the trellis code, the minimum squared Euclidean distance between parallel transitions would be equal to 4 (assuming the PSK signals are equally spaced on the unit circle and that signals which differ only in the most significant bit are on a diameter of the circle). If the punctured convolutional code of rate ((k-1)m-1)/(k-1)m has free Hamming distance $d_1$, then the free squared Euclidean distance of the trellis code is equal to the minimum of 4 and $d_1(2*\sin(360°/2^{k+1}))^2$.

Suppose, however, two uncoded binary digits are used for each of the m $2^k$-ary symbols. Then, there would be a total of 2m uncoded inputs and ((km-1)-2m)=((k-2)m-1) coded inputs. This would imply the use of a convolutional code punctured to rate ((k-2)m-1)/(k-2)m. The (k-2)m outputs of the binary convolutional encoder would be broken up into m groups each group containing (k-2) binary digits. The (k-2) binary digits from each group would be combined with two uncoded digits (with the uncoded digits being the two most significant bits of the k digits) to form a bundle of k binary digits. The result would be m bundles which are then mapped to m $2^k$-ary symbols. Since the uncoded digits represents parallel transitions in the decoder trellis for the trellis code, the minimum squared Euclidean distance between parallel transitions would be equal to 2 (assuming the PSK signals are equally spaced on the unit circle and that signals which differ only in the two most significant bits are separated by either 90° or 180°). If the punctured convolutional code of rate $((k-2)m1)/(k-2)m$ has free Hamming distance $d_2$, then the free squared Euclidean distance of the trellis code is equal to the minimum of 2 and $d_2(2^*\sin(360°/2^{k+1}))^2$.

One could conceive of having three or more uncoded bits for each of the m $2^k$-ary symbols. One might think that one should choose the number of uncoded bits per $2^k$-ary symbol solely on the basis of obtaining a trellis code with the maximum free squared Euclidean distance. However, the choice of the number of uncoded bits per $2^k$-ary symbol also effects the maximum speed of transmission for a single chip implementation. For example, assume that p uncoded bits were used for each of the m $2^k$-ary symbols so that a rate $((k-p)m-1)/(k-p)m$ punctured convolutional code is required. Assume that this code is formed by puncturing a rate 1/2 convolutional code where the puncturing is such that one takes a pair of outputs from the encoder and then punctures one of the two outputs for the next (k-p)m -2 inputs . If the chip which implements this punctured code can operate at a maximum information rate of 20 megabits per second, a single chip implementation of the trellis code will operate at a maximum information rate of 20*km/((k-p)-1) megabits per second. Note that this maximum rate is a monotonic decreasing function of p so that p=1 gives the largest information rate for a single chip implementation.

So far in the detailed description of exemplary implementations, it has been assumed throughout that the receiver has perfect knowledge of the phase of the transmitted carrier. In an improved implementation, a means whereby this assumption can be relaxed is described. The discussion will focus on the code given in Example 1 (a rate 5/6 trellis code for 8-PSK modulation) although the technique can be used for any of the codes described in the descriptions.

Recall that the mapping for 8-PSK modulation was: 0°=000, 45°=001, 90°=010, 135°=011, 180°=100, 225°=101, 270°=110, 315°=111. Note that for phase shifts of 45°, 135°, 225°, and 315°, exactly one of the two least significant bits will be complemented. The effect is as if the binary digits were transmitted over a binary symmetric channel with an error rate of 50%. The Viterbi decoder which attempts to decode these digits will see a very rapid growth of all of its path metrics. Since these path metrics have to be normalized whenever they get too large, the effect will be a large increase in the frequency of this normalization which can be detected. Whenever this occurs, the phase reference can be either increased or decreased by 45°.

However, in the cases of phase ambiguities of 90°, 180°, and 270°, note that for the assumed mapping, this set of phase shifts results in either both of the two least significant bits being complemented or neither of the two least significant bits being complemented. The rate 1/2, constraint length 7, (de-fact standard) convolutional code has the property that the complement of a code word is a code word. Thus, in the absence of other errors, if both of the least two significant bits are complemented the Viterbi decoder for the convolutional code will produce the complement of the correct information sequence. Thus, if the original input to the convolutional encoder had been differentially encoded using a 1/(1+D) (mod 2) encoder, then after differentially decoding at the receiver, the correct information sequence for the coded bits would be obtained. The problem of the uncoded bits (i.e., the most significant bits in the phase mapping) remains.

Note that for the set of phase shifts 90°, 180°, and 270°, if the binary vectors were divided into two sets depending upon whether their middle bit is a 0 or a 1, then in each set, the most significant bit is either complemented or not complemented. This suggests utilizing a controlled differential encoder for the uncoded bits where the control bit is the middle bit in the mapping. Such a controlled differential encoder is shown in Figure 6. Further details on this encoder and its application in trellis coded modulation is disclosed in copening U.S. Patent Application Serial No. 07/695,397 entitled "METHOD AND APPARATUS FOR RESOLVING PHASE AMBIGUITIES IN TRELLIS-CODED MODULATED DATE", filed May 3, 1991, now U.S. Patent No. 5,233,630, issued August 3, 1993, and assigned to the assignee of the present invention.

Referring to Figure 6, the input and output of encoder **50** is a binary stream. If the control signal is a 1 (0), the input is directed by multiplexer **51** to the top (bottom) differential encoder **52 (53)** and the output is taken from by multiplexer **54** from the top (bottom) differential encoder **52 (53)**. A controlled differential decoder has the same form except that the 1/(1+D) circuits are replaced by (1+D) circuits.

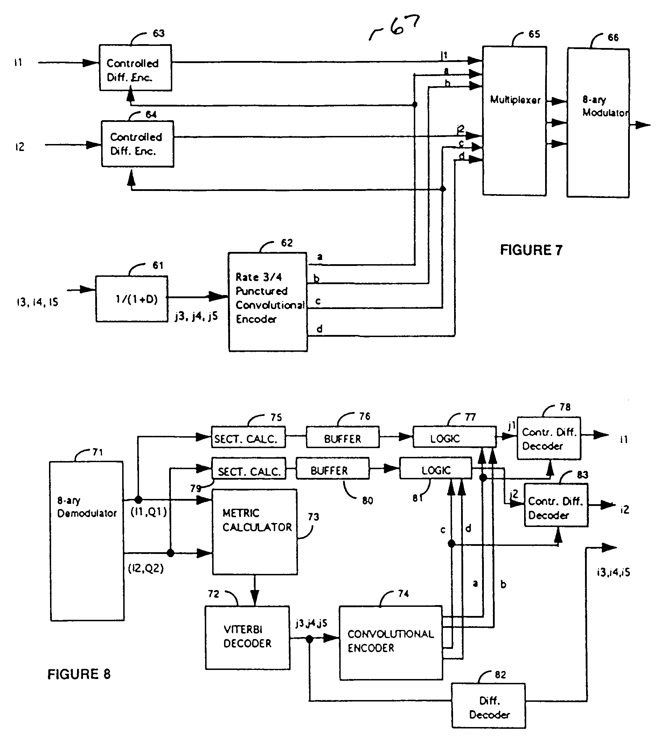

Referring now to FIGS. 7 and 8 an encoder and decoder for a rate 5/6 8-ary PSK system is illustrated. In FIG. 7, assume that the information bits i1, i2, i3, i4 and i5 are available at the input to the encoder **67**. As shown, i1 is the input to the controlled differential encoder **63**, i2 is the input to the controlled differential encoder **64** and i3, i4 and i5 are the inputs to the 1/(l+D) differential encoder **61**. The inputs i3, i4 and i5 produce the outputs j3, j4 and j5 in the usual manner for a $\frac{1}{1+D}$ differential encoder which is well known in the art. The equation describing the output of this differential encoder in terms of the input is given by equation (1) below:

$$k^{th} \text{ output} = (k-1)^{st} \text{ output} \oplus k^{th} \text{ input,} \qquad (1)$$

where ⊕ indicates modulo 2 addition. The input j3 now enters the rate 3/4 punctured convolutional encoder **62** producing the pair of outputs a, b. The pair of outputs (a, b) is bundled with the output j1 of controlled differential encoder **63** to be mapped into one of 8 phases. This takes place when the multiplexer **65** passes the bundle (j1, a, b) to 8-ary modulator **66**.

We now explain how the output j1 was produced by the controlled differential encoder **63**. The signal on line "a" is the control input to the controlled differential encoder **50** shown in FIG. 6. In this instance, the input to this circuit on the line labeled "INPUT" entering the multiplexer **51** is the information bit i1. If the control bit "a" is equal to a 0, the input i1 is directed by multiplexer **51** to the upper differential encoder circuit denoted **52** and output multiplexer **54** directs the output of the upper differential encoder **52** to the output line to form j1. If the control bit "a" is equal to 1, the input i1 is directed by multiplexer **51** to the lower differential encoder **53** and the output multiplexer **54** directs the output of the lower differential encoder **53** to the output line to form j1. The equations relating the input and output of the two differential encoders **52** and **53** are the same as described above.

We next input j4 into the rate 3/4 punctured convolutional encoder **62**. As described previously this produces the pair (c, X) where c is shown as one of the outputs of **62** and X denoted a punctured bit which is not shown because this bit is suppressed. The next input, j5, into the rate 3/4 punctured convolutional encoder **62** produces the output (X,d), where d is shown as one of the outputs of **62** and X is another punctured bit which is suppressed and thus not shown as one of the outputs of encoder **62**. The pair (c,d) is now bundled with the output j2 of the controlled differential encoder **64** to be mappped into another one of 8 phases. This takes place when the multiplexer **65** passes the bundle (j2, a, b) to the 8-ary modulator **66**.

The output j2 is produced by the controlled differential encoder **64** in the following manner. The signal on line "a" is now the control input to a circuit which is another copy of circuit **50** shown in FIG. 6. In this instance, the input to this circuit (shown as the arrow to the right entering the device **51**) is the information bit i2. If the control bit "c" is equal to a "0", the input i1 is directed by multiplexer **51** to the upper differential encoder **52** and the output multiplexer **54** directs the output of the upper differential encoder **52** to the output line to form j2. If the control bit "c" is equal to a "1", the input i1 is directed by multiplexer **51** to the lower differential encoder, **53**, and the output multiplexer **54** directs the output of the lower differential encoder **53** to the output line to form j2. The equations relating the input and output of the two differential encoders are again as described before.

FIG. 8 illustrates an exemplary decoder for trellis coded modulation of the type discussed herein. For purposes of explanation, the exemplary encoder of FIG. 8 is configured for decoding 8-PSK modulated data for a rate 5/6 punctured trellis code. However it should be understood that other rates and modulation types may be readily derived therefrom.

The decoder in FIG. 8 is an extension of the trellis decoder incorporated within the Q1875 chip with an additional circuitry for recovering an additional uncoded bit. In FIG. 8, 8-ary PSK demodulator **71** provides two sets of phase data as I and Q samples (I1, Q1) and (I2, Q2), one for each received encoded group for the 5/6 encoded data. The (I1, Q1) and (I2, Q2) samples are both provided to metric calculator **73** for computing metrics associated with each set of I and Q phase data. The computed branch metrics are provided to Viterbi decoder **72** for generating estimates of the data bits j3, j4 and j5. The bits j3, j4, and j5 are provided through differential decoder **82** (having a function of (1+D)) to produce estimates of the bits i3, i4, and i5.

The (I1, Q1) and (I2, Q2) samples are respectively provided to sector calculators **75** and **79** where a 3-bit sector value corresponding to the received phase of the signal is generated. These sector values are hard decision estimates of the value for which the transmitted phase represented. These values are respectively provided to buffers **76** and **80** and then to logic **77** and **81**.

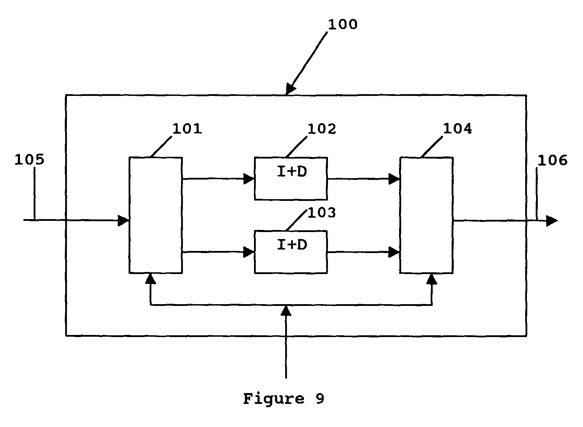

Returning to the output of Viterbi decoder **72** the bits j3, j4, and j5 are also provided to convolutional encoder **74** for re-encoding in an identical manner in which they were encoded for transmission. The estimate of j3 enters rate 3/4 punctured convolutional encoder **74**, producing the pair of outputs (a, b). The signal on line "a" is the control bit to the controlled differential decoder **78** which is shown as **100** in FIG. 9. The input to this circuit on line **105** is the estimate of j1. If the control bit "a" is equal to "0", the input j1 is directed by mux **101** to the upper (1+D) differential decoder, **102** and the output multiplexer **104** directs the output of the upper (1+D) differential decoder **102** to the output line **106** to form the estimate of I. If the control bit is equal to a 1, the input j1 is directed by multiplexer **101** to the lower (1-D) differential decoder, **103** and the output mux **104** directs the output of the lower (1+D) differential decoder **103** to the output line **106** to form the estimate of I1.

The equations relating the input and output of the two (1+D) differential decoders are:

$$k^{th} \text{ output} = k^{th} \text{ input} \oplus (k-1)^{st} \text{ input}, \qquad\qquad (2)$$

where ⊕ indicates modulo 2 addition. We next must input the estimates of j4 into the rates 3/4 punctured convolutional encoder **74**. As described previously, this produces the pair (c, X) where c is shown as one of the outputs of **74** and X denotes a punctured bit which is not shown because this bit is suppressed. The next input to the rate 3/4 convolutional encoder **74** is the estimate of j5. This produces the output (X, d) where d is shown as one of the outputs of **74** and X is another punctured bit which is suppressed and thus is not shown. The output j2 of the controlled differential decoder **83** is produced in a manner similar to how j1 was produced by the controlled differential decoder **78** but now the control bit is the bit on line "c".

We again refer to FIG. 9 to give the details of this operation. Now, the input to differential decoder **100** on line **105** is the estimate of j2 and the control bit is "c". If the control bit "c", is equal to a "0", the input j2 is directed by multiplexer **101** to the upper (1+D) differential decoder, **102**, and the output multiplexer **104** directs the output of the upper (1+D) differential decoder **102** to the output line **106** to form the estimate of i2. If the control bit "c" is equal to a "1", the input j2 is directed by multiplexer **101** to the lower (1+D) differential decoder, **103**, and the output mux **104** directs the output of the lower (1+D) differential decoder to the output line **106** to form the estimate of i2.

The output from encoder **74** are the symbol estimates a, b, c, and d. The symbol estimates a and b are provided to logic **77**, while the symbol estimates c and d are provided to logic 81. These symbol estimates are used by logic **77** and **81** to correct for errors in the uncoded bit represented in the transmitted 3-bit value. It should be noted that in each sector value provided to logic **77** and **81** two of the bits are hard decision estimates of the a and b transmitted bits. The remaining bit in each sector value is a hard decision estimate of the uncoded bit j1 or j2. Details on this correction is disclosed in further detail in copending U.S. Patent Application Serial No. 07/695,397 entitled "VITERBI DECODER BIT EFFICIENT CHAINBACK MEMORY METHOD AND DECODER INCORPORATING SAME", filed September 27, 1991, and assigned to the assignee of the present invention. The bit estimates j1 and j2 output from logic **77** and **81** are respectively provided to controlled differential decoders **78** and **83**. Decoders **78** and **83** respectively receive the symbol estimates a and c as the control input for controlling the multiplexed differential decoding of the bit estimates j1 and j2. As a result of the decoding of decoders **78** and **83** the bit estimates i1 and i2 are produced.

The previous description of the preferred embodiments is provided to enable any person skilled in the art to make or use the present invention. The various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope consistent with the principles and novel features disclosed herein.

## Claims

1. A method for trellis encoding data for transmission using M-ary phase shift key (PSK) modulation having M phase states comprising the steps of:

   receiving n input data bits;
   encoding according to a first encoding format a subset of k bits of said input data bits to provide a first set of symbols; and
   combining said first set of symbols and remaining n-k input data bits to provide transmission sets.

2. The method of claim 1 wherein said transmission sets comprise $\log_2(M)$ symbol bits.

3. The method of claim 1 or 2 wherein

   n is an integer multiple of $\log_2(M)$ less one according to the formula

   $$n = m \cdot \log_2(M) - 1$$

   where m is an integer; and
   said set of symbols is comprised of k+1 symbol bits.

4. The method as set forth in any of claims 1-3 wherein said encoding step is performed via the step of:

   performing rate ½ encoding on said subset of k bits yielding 2k symbol bits; and
   puncturing k-1 of said symbols bits yielding k+1 remaining symbol bits.

5. The method as set forth in any of claims 1-4 wherein

   M is equal to 8;
   n is equal to 5; and
   k is equal to 3.

6. The method as set forth in any of claims 1-4 wherein

    M is equal to 8;
    n is equal to 8; and
    k is equal to 5.

7. The method as set forth in any of claims 1-4 wherein

    M is equal to 16;
    n is equal to 7; and
    k is equal to 3.

8. The method as set forth in any of claims 1-4 wherein

    M is equal to 16;
    n is equal to 11; and
    k is equal to 5.

9. A method for trellis encoding data for transmission using M-ary phase shift key (PSK) modulation having M phase states comprising the steps of:

    receiving n input data bits;
    differentially encoding a first subset of k input data bits yielding differential input data bits;
    encoding according to a first encoding format said differential input data bits to provide a coded symbol set;
    controlled differential encoding a first input data bit based on a first symbol bit from said coded symbol set yielding a first controlled differential input bit;
    controlled differential encoding a second input data bit based on a second symbol bit from said coded symbol set yielding a second controlled differential input bit;
    combining said coded symbol set, said first controlled differential input bit and said second controlled differential input bit to provide transmission sets for M-ary PSK modulation.

10. The method as set forth in claim 9 wherein said transmission sets are comprised of $\log_2(M)$ transmission bits.

11. The method of claim 9 wherein

    n is equal to 5; and
    k is equal to 3.

12. A method for demodulating a received, encoded M-ary PSK signal comprising the steps of:

    demodulating the M-ary PSK signal (71) yielding demodulated data;
    generating branch metrics;
    generating decision data by decoding said branch metrics;
    generating re-encoded data by re-encoding said decision data;
    determining a sector based on said demodulated data; and
    controlled decoding said sector based on said re-encoded data.

13. The method of demodulating of claim 12 further comprising the step of:

    correcting errors in said sector based on said re-encoded data.

14. A method of demodulating a received, differentially encoded M-ary PSK signal comprising the steps of:

    demodulating the M-ary PSK signal (71) yielding demodulated data;
    generating branch metrics;
    generating decision data by decoding said branch metrics;
    generating re-encoded data by re-encoding said decision data;
    determining a sector based on said demodulated data; and

controlled differential decoding said sector based on said re-encoded data.

**15.** The method of demodulating of claim 14 further comprising the step of:

correcting errors in said sector based on said re-encoded data.

**16.** The method of demodulating of claim 14 or 15 further comprising the step of:

differentially decoding said decision data.

**17.** A trellis encoder for transmitting data using M-ary phase shift key (PSK)

modulation having M phase states comprising:

means for receiving n input data bits;
means for encoding according to a first encoding format a subset of k bits of said input data bits to provide a first set of symbols;
means for combining said first set of symbols and remaining n-k input data bits to provide transmission sets.

**18.** The trellis encoder of claim 17 wherein said transmission sets comprise $\log_2(M)$ symbol bits.

**19.** The trellis encoder of claim 17 wherein

n is an integer multiple of $\log_2(M)$ less one according to the formula

$$n = m \cdot \log_2(M) - 1$$

where m is an integer; and
said set of symbols is comprised of k+1 symbol bits.

**20.** The trellis encoder of any of claims 17-19 wherein said encoding step is performed via the step of:

performing rate ½ encoding on said subset of k bits yielding 2k symbol bits; and
puncturing k-1 of said symbols bits yielding k+1 remaining symbol bits.

**21.** The trellis encoder of any of claims 17-20 wherein

M is equal to 8;
n is equal to 5; and
k is equal to 3.

**22.** The trellis encoder of any of claims 17-20 wherein

M is equal to 8;
n is equal to 8; and
k is equal to 5.

**23.** The trellis encoder of any of claims 17-20 wherein

M is equal to 16;
n is equal to 7; and
k is equal to 3.

**24.** The trellis encoder of any of claims 17-20 wherein

M is equal to 16;
n is equal to 11; and

k is equal to 5.

**25.** The trellis encoder of any of claims 17-20 wherein

n is equal to 5;and
k is equal to 3.

**26.** The trellis encoder as set forth in any of claims 17-25 wherein said transmission sets are comprised of $\log_2(M)$ transmission bits.

**27.** A trellis encoder for trellis encoding data for transmission using M-ary phase shift key (PSK) modulation having M phase states comprising:

means for receiving n input data bits;
means for differentially encoding a first set of k input data bits yielding differential input data bits;
means for encoding according to a first encoding format said differential input data bits to provide a coded symbol set;
means for controlled differential encoding a first input data bit based on a first symbol bit from said coded symbol set yielding a first controlled differential input bit;
means for controlled differential encoding a second input data bit based on a second symbol bit from said coded symbol set yielding a second controlled differential input bit;
means for combining said coded symbol set, said first controlled differential input bit and said second controlled differential input bit to provide transmission sets for M-ary PSK modulation.

**28.** The trellis encoder as set forth in claim 27 wherein said transmission sets are comprised of $\log_2(M)$ transmission bits.

**29.** The trellis encoder of claim 27 or 28 wherein

n is equal to 5; and
k is equal to 3.

**30.** A demodulator for receiving an encoded M-ary PSK signal comprising:

M-ary demodulator (71) for demodulating the M-ary PSK signal (71) yielding demodulated data;
metric calculator (73) for generating branch metrics;
Viterbi decoder (72) for generating decision data by decoding said branch metrics;
convolutional encoder (74) for generating re-encoded data by re-encoding said decision data;
sector calculator (75) for determining a sector based on said demodulated data; and
controlled decoder (78) for controlled decoding said sector based on said re-encoded data.

**31.** A demodulator for receiving a differentially encoded M-ary PSK signal comprising:

M-ary demodulator (71) for demodulating the M-ary PSK signal (71) yielding demodulated data;
metric calculator (73) for generating branch metrics;
Viterbi decoder (72) for generating decision data by decoding said branch metrics;
convolutional encoder (74) for generating re-encoded data by re-encoding said decision data;
sector calculator (75) for determining a sector based on said demodulated data; and
controlled differential decoder (78) for controlled differential decoding said sector based on said re-encoded data.

**32.** The demodulator of claim 31 further comprising:

differential decoder for differentially decoding said decision data

**33.** The demodulator of any of claims 30-32 further comprising:

logic circuit for correcting errors in said sector based on said re-encoded data.

iN

$i_{k+1}$

$i_k$

$i_1$

Rate 1/2 Encoder Punctured to Rate k / k+1

1

$a_{k+1}$
$a_k$

$a_1$

$i_N$

$i_{k+1}$
$a_{k+1}$
$a_k$

$a_1$

Multiplexer

2

$O_1$

$O_L$

M-ary Modulator

3

FIGURE 1

I1

I2

I3
I4

I5

Rate 1/2 Encocoder Punctured to Rate 3/4

11

i1
a
b

i2
c
d

Multiplexer

12

8-ary Modulator

13

FIGURE 2

FIGURE 3

FIGURE 4

FIGURE 5

FIGURE 6

FIGURE 7

FIGURE 8

Figure 9

| | European Patent Office | EUROPEAN SEARCH REPORT | Application Number EP 97 12 1772 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | WOLF J K ET AL: "P2 CODES: PRAGMATIC TRELLIS CODES UTILIZING PUNCTURED CONVOLUTIONALCODES" IEEE COMMUNICATIONS MAGAZINE, vol. 33, no. 2, February 1995, pages 94-99, XP000505676 paragraphs entitled "Punctured convolutional codes" and "A P2 code for 8-PSK" | 1-5, 17-21,26 | H03M13/00 |
| Y | | 9-11, 27-29 | |
| X | WOERZ T ET AL: "DECODING OF M-PSK-MULTILEVEL CODES" EUROPEAN TRANSACTIONS ON TELECOMMUNICATIONS AND RELATED TECHNOLOGIES, vol. 4, no. 3, 1 May 1993, pages 299-308, XP000385756 * paragraph 3; table 1 * | 1-3, 17-19 | |
| X | WOERZ T ET AL: "PERFORMANCE OF PUNCTURED PRAGMATIC CODES" GLOBECOM '95. IEEE GLOBAL TELECOMMUNICATIONS CONFERENCE, SINGAPORE, NOV. 14 - 16, 1995, vol. 1, 14 November 1995, pages 664-669, XP000621566 INSTITUTE OF ELECTRICAL AND ELECTRONICS ENGINEERS * paragraph 1; table 1 * | 1-3, 17-19 | TECHNICAL FIELDS SEARCHED (Int.Cl.6)<br><br>H03M<br>H04L |
| X | WO 92 20162 A (QUALCOMM INC) 12 November 1992 * page 13, line 30 - page 18, line 11; figure 3 * | 12-16, 30-33 | |
| Y | * page 10, line 26 - page 13, line 29; figures 2,6 * | 9-11, 27-29 | |

-/--

The present search report has been drawn up for all claims

| Place of search | Date of completion of the search | Examiner |
|---|---|---|
| THE HAGUE | 15 October 1998 | Augarde, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 97 12 1772

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US 5 428 631 A (ZEHAVI EPHRAIM) 27 June 1995 * figure 5 * ----- | 12,14, 30,31 | |
| | | | TECHNICAL FIELDS SEARCHED (Int.Cl.6) |

The present search report has been drawn up for all claims

| Place of search | Date of completion of the search | Examiner |
|---|---|---|
| THE HAGUE | 15 October 1998 | Augarde, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document